# EUROPEAN PATENT APPLICATION

(11) **EP 1 976 022 A2**
(43) Date of publication of application: **01.10.2008**
(21) Application number: 07105278.1
(22) Date of filing: 29.03.2007
(51) Int. Cl.: H01L 31/0216, H01L 21/318, C23C 14/35, C23C 14/54

(54) **Method and device for producing an anti-reflection or passivation layer for solar cells**

(71) Applicant: Applied Materials, Inc., Santa Clara, CA 95054 (US)
(72) Inventor: Trassl, Roland, 35392, Gießen (DE); Schramm, Sven, 97070, Würzburg (DE); Hegemann, Thomas, 63579, Freigericht-Neuses (DE)
(74) Representative: Lang, Christian

(57) **Abstract**

The present invention relates to a method of producing an anti-reflection and/or passivation coating for solar cells comprising the steps of providing a silicon wafer in a deposition chamber, pre-heating of said silicon wafer to a temperature above 400 ° C and deposition of a hydrogen containing anti-reflection and/or passivation coating by a sputter process as well as to a coating apparatus for producing solar cells , especially anti-reflection and/or passivation coatings on Si wafers, especially for carrying out the inventive method, comprising a first vacuum chamber (1), a second vacuum chamber (2) and conveying means (4) for transporting a substrate (5) through said first and second vacuum chambers in this order, said first vacuum chamber comprising at least one infrared radiation heater (16) being capable to be heated such that a heater filament has a temperature between 1800°C and 3000°C and said second vacuum chamber comprising sputter means (12) for vaporization of a target as well as a gas inlet for introducing a reactive gas including hydrogen.

## Description

### Technical Field

The invention refers to a method of producing an anti-reflection or passivation coating for solar cells as well as to a coating apparatus for producing solar cells, especially by using the corresponding method.

### Background Art

The production of solar cells on the basis of silicon wafers is usually carried out by doping basically already doped silicon wafers with a dopant having properties to establish a p- or n-type conductivity being different to the originally doped material. For example, a boron doped silicon wafer showing p-type conductivity may be treated by a diffusion process using for example POCl₃ in order to incorporate phosphorus and establish a n-type layer. After formation of such a p-n-junction an anti-reflection coating or passivation layer has to be formed on the surface of the substrate. This is usually carried out by a plasma enhanced chemical vapor deposition (PECVD) process.

In order to avoid using of the highly explosive silane of the PECVD-process and to scale up the coating area, it was reported by Winfried Wolke et al. at the 19th European photovoltaic solar energy conference in Paris/France 2004 ("SiN:H anti-reflection coating for C-Si solar cells by large scale inline sputtering") that a reactive sputter process may be used for applying a hydrogen containing anti-reflection or passivation coating. For this purpose a horizontally operated inline coating apparatus of the ATON-series (ATON is a trademark of former Applied Films and now Applied Materials) was used. Details are described in the above mentioned article of Winfried Wolke et al. which is completely incorporated into the specification of the present application by reference.

According to this prior art, the wafers were preheated to a temperature of 200 ° C to 400 ° C before applying the anti-reflection or passivation coating onto the silicon wafer.

### Disclosure of Invention

Object of the Invention

The object of the present invention is to further improve the method of producing an anti-reflection or passivation coating for solar cells of the type described above. Besides the improvement of the coating properties and the overall characteristics of the solar cell, the novel method should be carried out in a simple, reliable and effective way. In addition, an appropriate coating apparatus for carrying out such a method should be provided for.

Technical Solution

This object is solved by a method having the features of claim 1 as well as a coating apparatus having the features of claim 12. Preferred embodiments are the subject matter of the dependent claims.

The inventors of the present invention have found out that the properties of the anti-reflection or passivation coating as well as of the solar cell at all can be improved if the pre-heating temperature is increased before carrying out the deposition of the anti-reflection or passivation layer by a sputter process. Especially for specific wafer types the higher pre-heating temperatures are beneficial with respect to hydrogen passivation. Accordingly, the pre-heating temperature according to the present invention is increased over the temperatures used in prior art, namely to temperatures above 400 ° C, especially above 450 ° C, preferably above 500 ° C.

The inventive method can advantageously be applied to the deposition of a hydrogen containing silicon nitride layer of the composition SiNₓ:H with variable contents of nitrogen and hydrogen on doped silicon wafers as described in the above-referenced article of Winfried Wolke et al.

The pre-heating can preferably be carried out by radiation heaters like infrared heaters which assure high heating rates and low heating-up times. Preferred heating-up times are in the range of 100 s or lower, especially 50 seconds or lower, although other heating-up times may be applicable. Accordingly, the heating-up rates can be chosen to be 4 K/s or above, preferably 10 K/s or above.

In order to achieve an effective absorption of the radiation emitted by the radiation heaters, infrared heaters may be employed which can be run with filament temperatures between 1800 ° C and 3000 ° C. At this filament temperature the radiation emitted by the infrared heaters has a wavelength in the range of 1.0 to 1.4 µm. This wavelength of the infrared radiation is absorbed by the silicon wafers in a very effective way.

In order to avoid undesired effects during pre-heating, like oxidation of the wafer surface, the pre-heating step can be carried out under technical vacuum conditions. Thus, the deposition chamber, in which the pre-heating is carried out, is rather a vacuum chamber than a deposition chamber. The pressure in the deposition or vacuum chamber, where the pre-heating takes place, can be set to values of 100 hPa or below, preferably lower than 10⁻² hPa or 10⁻⁵ hPa.

The sputter process following the pre-heating step may be carried out as described in the article of Winfried Wolke et al. mentioned above. Especially, the reactive sputter process may use silicon targets to be sputtered by argon ions created from an argon plasma and reactive gases containing nitrogen, hydrogen or ammonia introduced into the deposition chamber. The plasma can be generated by a double-electrode arrangement as for example the twin-mag arrangement of Applied Films, now Applied Materials, which uses two electrodes being alternatly operated as cathode or anode so that the target material disposed in front of the electrodes or the electrode material itself is alternately sputtered by impinging ions. The frequency used for the AC- or pulsed voltage supply can be selected in the range of medium frequency to radio frequency (kHz to MHz).

According to the present invention, a coating apparatus comprises at least a first vacuum chamber, a second vacuum chamber and conveying means for transporting a substrate, like a silicon wafer through the first and the second vacuum chamber in this order. In the first vacuum chamber pre-heating of the substrate is carried out by infrared radiation heaters so that high wafer temperatures, especially in the range of above 400 ° C are achievable. Accordingly, infrared heaters are used, the filaments of which are capable to reach temperatures between 1800 ° C and 3000 ° C in order to achieve high substrate temperatures at high heating-up rates and low pre-heating times.

In the second vacuum chamber the deposition of a layer by a reactive sputtering process is accomplished.

The coating apparatus can be a horizontally or vertically operated inline coating apparatus, which means that the substrates can be transported through the coating apparatus during pre-heating and layer deposition in almost horizontal or vertical orientation.

Although the first and second vacuum chambers may be designed as a single device having only a single housing, a modular design with chambers which can be separated is also conceivable.

The infrared radiation heaters can be disposed across the transport direction of the substrate so that by passing the radiation heater during movement of the substrate through the first vacuum chamber, the substrate is heated up by the radiation absorbed from the substrate.

In order to achieve a complete and homogeneous heating of the substrate, the effective heating length of the infrared radiation heater can exceed the width of the substrate or of the substrate holder of the conveying means.

Preferably, a plurality of infrared heaters is disposed one-by-one in a transport direction of the substrate, wherein the infrared heaters may be arranged parallel to each other. Thus, an effective and homogeneous heating of the substrate is achieved.

In order to be able to control the temperature of the substrate, the infrared heaters may be designed such to be individually switchable and/or controllable. This also leads to the advantage that a failure of a single heater may be compensated by one of the other heaters.

Thus, the heating arrangement of the infrared heaters is preferably designed such that a single heater is sufficient for achieving the necessary temperatures of the substrate so that the remaining heaters can be used as a buffer, if one of the heaters turns out. This has the advantage that the coating apparatus and accordingly the vacuum have not to be shut down in case of failure of one heater.

In order to avoid contamination of the vacuum or deposition chambers by evaporation of reflection layers of the heaters, such reflection layers are omitted. Instead of reflection layers being deposited on a surface, reflection surfaces in form of polished metal surfaces are used to reflect the radiation of the heaters to the interior of the vacuum chamber and to the substrate.

The side walls of the vacuum chamber may be equipped with cooling means, like cooling coils, which are flown through by cooling fluid, like water. Thus, the heat lowed of the vacuum chamber can be significantly reduced.

The infrared heaters may be arranged at a closure element of the vacuum chamber, particularly at a top cover of the vacuum chamber in case of a horizontally operated coating apparatus to be easily removed for maintenance and service purposes.

### Brief Description of Figures

Further characteristics, advantages and features will be described in the following detailed description of a preferred embodiment with reference to the accompanied drawings. The drawings show in purely schematic form in

Fig. 1 a longitudinal cross section through an inline coating apparatus according to the present invention; and in

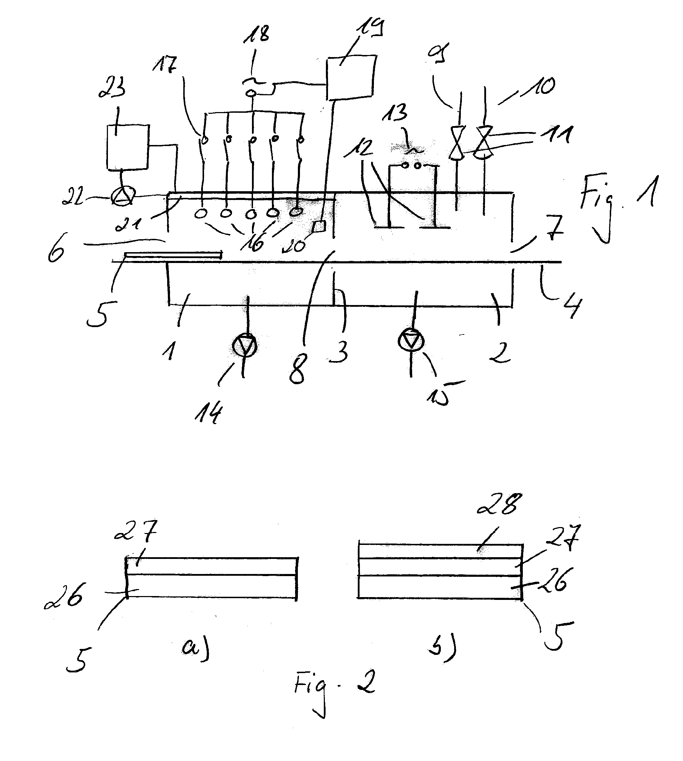

Fig. 2 a) a cross section through a Si-Wafer before treatment according to the inventive method and

b) after treatment in the coating apparatus of Fig. 1 according to the inventive method.

Fig. 1 shows in a pure schematic drawing a longitudinal cross section of an inline coating apparatus. The coating apparatus of fig. 1 comprises two vacuum chambers 1 and 2 being arranged adjacent to each other. The vacuum chambers 1 and 2 are separated by a vacuum chamber wall 3 having an opening or a lock 8 for transport of a substrate to be treated from the first vacuum chamber 1 to the second vacuum chamber 2. The vacuum chamber wall 3 may be formed by two separate walls, each of which belonging to one of the vacuum chambers 1, 2, so that the vacuum chambers 1 and 2 may be separated. Alternatively, the vacuum chambers 1 and 2 may be made of one single housing, so that the vacuum chambers 1 and 2 cannot be separated. In this case, the vacuum chamber wall 3 is accordingly designed as a pure partition wall.

The reference numeral 4 designates a conveying belt or similar conveying means including substrate holders, drive means etc. The conveyer 4 extends through both vacuum chambers 1 and 2 as well as through the feed-in opening 6 and output opening 7. Both openings, namely feed-in opening 6 as well as output opening 7 may be closed by lock devices (not shown), which allow introducing or dispensing, respectively, of the substrate 5 without disturbing the vacuum conditions within the vacuum chambers 1 and 2.

For establishing vacuum conditions within the vacuum chambers 1 and 2 vacuum pumps 14 and 15 are provided for at the vacuum chambers 1 and 2. Instead of one vacuum pump for each vacuum chamber, a common vacuum pump for both vacuum chambers or several vacuum pumps for each vacuum chamber may be provided for. The vacuum pumps 14, 15 are designed such to allow establishing of technical vacuum conditions which means a pressure inside the vacuum chamber below 100 hPa, especially below 10⁻³ hPa, particularly below 10⁻⁵ hPa.

The vacuum chamber 1 is the pre-heating chamber in which the pre-heating step, according to the present invention, is carried out. For this purpose several infrared heaters 16 are disposed one-by-one with respect to the transport direction of the substrate 5, which is in fig. 1 from the left to the right.

The infrared heaters 16 are arranged across the transport direction, so that they extend perpendicular to the image plane. As can be seen from fig. 1, the infrared heaters 16 are arranged parallel to each other as well as equally spaced to each other.

The length of the infrared heaters extending perpendicular to the image plain of fig. 1 is chosen such that in projection from the top side of the vacuum chamber 1 the infrared heaters exceed the width of the substrates or even the conveying means on which the substrates are located during their movement through the inline coating apparatus. Thus, an homogeneous and effective heating up in all areas of the substrate is achieved.

The infrared heaters 16 are of the type which allow very high temperatures. The achievable temperatures are in the range of 1800 ° C to 3000 ° C, which means that the filament of the infrared heater is at that temperature during operation, if desired. This kind of infrared heater is in particular suitable for heating of silicon wafers, since the wavelength of the radiation emitted by the infrared heater at such temperatures allows very good absorption of the infrared radiation by the silicon. Accordingly, very high wafer temperatures above 400 ° C, especially above 450 ° C and particularly above 500 ° C are obtainable. The high wafer temperature again is advantageous with respect to the following deposition of an anti-reflection or passivation layer and in particular for the passivation with hydrogen containing gases and/or layers.

Although, several infrared heaters 16 are shown in the vacuum chamber 1, it would be sufficient to have only one infrared heater 16. Since the substrate is moved underneath the infrared heaters, the operation of only one infrared heater 16 would be sufficient to heat up the whole substrate 5. Accordingly, the infrared heaters 16 are individually switchable, as indicated by the switches 17 to which the infrared heaters 16 are connected. The switches 17 are arranged between a power supply 18 and the infrared heaters 16, so that every single infrared heater can be switched off separately and independently. Instead of simple switches other suitable control means may be used which not only allow simple switching off, but controlling of the power of every infrared heater.

Since every infrared heater can be operated separately and independently, the heating arrangement can be designed such that the operation of one infrared heater is sufficient, so that in case of a failure of one infrared heater the apparatus as well as the vacuum in the vacuum chambers have not to be shut down, since one of the remaining infrared heaters 16 being ready for operation can be used. This increases the operational availability of the inline coating apparatus effectively.

In order to control the temperature of the substrate, a measuring device 20 in form of a sensor or pyrometer is provided for. The measuring device is connected to a control system 19 which controls the heating arrangement depending on the measured temperature value.

At the side wall of the vacuum chamber 1, at which the infrared heaters are arranged, a reflection surface 21 is provided for which reflects the radiation of the infrared heaters 16 towards the interior of the vacuum chamber 1 as well as the substrate 5. In order to avoid the evaporation of any reflection coating of the infrared heaters or of the reflection surface 21, such a reflection coating is omitted. Instead of this, the reflection surface 21 is formed by a polished metal surface which enables a very good reflection and avoids any contamination of the vacuum chamber 1.

The reflection surface 21 is also provided with cooling coils through which a cooling fluid like water is passed. Driven by the pump 22, the cooling fluid flows through an external cooling means 23 to keep the temperature of the cooling fluid constant.

During movement through the vacuum chamber 1, the substrate 5 is heated up to a temperature of more than 400 ° C, especially more than 450 ° C or more than 500 ° C. After that, the substrate 5 is introduced into the vacuum chamber 2, wherein the coating process is carried out.

For this purpose the vacuum chamber 2 comprises two electrodes 12 which are used as targets and connected to a power supply 13 which is operated with a frequency in the range of radio frequency.

The vacuum chamber 2 also comprises two gas supply means 9 and 10 which are lockable by valves 11.

The first gas supply means 9 is connected to a working gas supply (not shown), for example an argon gas supply.

The second gas supply means 10 is connected to a reactive gas supply (not shown), for example nitrogen, hydrogen, hydrocarbon C_{X}H_{y}, Si containing gases or ammonia gases.

Due to the RF-power applied to the electrodes 12 which comprise a target in front of the electrode surface or are made from an appropriate target material, a plasma is ignited by the RF-discharge and the targets are sputtered by impinging ions. Due to the reactive gases introduced into the vacuum chamber 2 a reaction product from the sputtered target material and the reactive gases is deposited on the substrate 5.

Preferably, a hydrogenated silicon nitride-film having the composition of SiNₓ:H is formed on the top of the substrate 5. Due to the high temperature of the substrate originating from the treatment in the vacuum chamber 1, a very good hydrogen passivation by the hydrogen containing gas is achieved.

Fig. 2 shows a purely schematic example of the structure of a Si wafer during pre-heating in the vacuum chamber 1 (a) and after deposition of the coating in the vacuum chamber 2 (b). The substrate 5 introduced into the vacuum chamber 1 may have a two-layer structure comprising a boron doped layer 26 and a phosphorus doped layer 27. Usually, the bulk raw Si-material is already doped with boron and the phosphorus doped n-layer is produced by a separate diffusion process (not shown).

After coating with the SiNₓ:H-layer 28 a three-layer structure of the Si-wafer with the p-layer 26 and the n-layer 27 as well as an anti-reflection and passivation layer 28 is formed.

Although, the present invention was described in detail with respect to a preferred embodiment, it is evident for a man skilled in the art that alterations and amendments may be carried out, especially with respect to a different combination of disclosed features as well as omitting single features without leaving the scope of protection defined by the accompanying claims.

## Claims

1. Method of producing an anti-reflection and/or passivation coating for solar cells, comprising the following steps:
providing a Si wafer (5) in a deposition chamber (1);
pre-heating of said Si wafer to a temperature above 400°C; and
deposition of a hydrogen containing anti-reflection or passivation coating (28) by a sputter process.

2. Method according to claim 1,
**wherein**
a doped Si wafer (5) is used.

3. Method according to claim 1 or 2,
**wherein**
the anti-reflection or passivation coating (28) is a SiN:H layer.

4. Method according to any of the previous claims,
**wherein**
heating-up during said pre-heating step is carried out by heat radiation elements (16).

5. Method according to claim 3,
**wherein**
infrared heaters (16) are used.

6. Method according to claims 3 or 4,
**wherein**
infrared heaters (16) are used which are capable to be run with filament temperatures between 1800°C and 3000°C and/or emit radiation with a wavelength in an absorption range of silicon.

7. Method according to any of the previous claims,
**wherein**
short heating-up times equal or lower than 100 s, preferably equal or lower than 50 s and/or heating-up rates of 4 K/s and above, preferably 10 K/s and above are used.

8. Method according to any of the previous claims,
**wherein**
said Si wafers are heated up during the pre-heating to temperatures equal or above 450°C, particularly equal or above 500°C.

9. Method according to any of the previous claims,
**wherein**
said pre-heating step is carried out in an inline coating apparatus during motion of said Si wafer.

10. Method according to any of the previous claims,
**wherein**
said pre-heating step is carried out under technical vacuum conditions.

11. Method according to any of the previous claims,
**wherein**
said sputter process comprises at least a reactive sputter step.

12. Coating apparatus for producing solar cells, especially anti-reflection and/or passivation coatings on Si wafers, especially for carrying out the method according to any of the previous claims, comprising a first vacuum chamber, a second vacuum chamber (2) and conveying means (4) for transporting a substrate (5) through said first and second vacuum chambers in this order, said first vacuum chamber comprising at least one infrared radiation heater (16) being capable to be heated such that a heater filament has a temperature between 1800°C and 3000°C and said second vacuum chamber comprising sputter means (12) for vaporization of a target as well as a gas inlet (10) for introducing a reactive gas including hydrogen.

13. Coating apparatus according to claim 12,
**wherein**
first and second vacuum chambers (1, 2) comprise a single housing or separate modular housings.

14. Coating apparatus according to claims 12 or 13,
**wherein**
said infrared radiation heater (16) is disposed across a transport direction of said substrate.

15. Coating apparatus according to claim 14,
**wherein**
an effective heating length of said infrared radiation heater (16) exceeds the width of said substrate or said conveying means.

16. Coating apparatus according to any of claims 12 to 15,
**wherein**
a plurality of infrared heaters is disposed one by one in a transport direction of said substrate, especially with said infrared heaters arranged parallel to each other.

17. Coating apparatus according to claim 16,
**wherein**
said infrared heaters are individually switchable and/or controllable.

18. Coating apparatus according to any of claims 12 to 17,
**wherein**
said infrared heater (16) is arranged at a side wall of the housing, especially a closure element, particularly a top cover.

19. Coating apparatus according to any of claims 12 to 18,
**wherein**
said infrared heater is without any reflection coating.

20. Coating apparatus according to any of claims 12 to 19,
**wherein**
at least one side wall of the housing comprises a reflection surface (21) being a polished metal surface.

21. Coating apparatus according to claim 20,
**wherein**
said reflection surface (21) comprises cooling means, especially in form of cooling coils with a cooling fluid flowing through.
